# EUROPÄISCHE PATENTSCHRIFT

(11) **EP 0 505 372 B1**
(45) Veröffentlichungstag und Bekanntmachung des Hinweises auf die Patenterteilung: **01.02.1995**
(21) Anmeldenummer: 90916708.2
(22) Anmeldetag: 14.11.1990
(51) Int. Cl.: G01R 33/06

(54) **VERFAHREN UND VORRICHTUNG ZUR ÜBERPRÜFUNG EINES HALL-SENSORSYSTEMS**
PROCESS AND DEVICE FOR TESTING A HALL SENSOR SYSTEM
PROCEDE ET DISPOSITIF POUR LE CONTROLE D'UN SYSTEME DE MESURE A EFFET HALL

(30) Priorität: 15.12.1989 DE 3941473
(43) Veröffentlichungstag der Anmeldung: 30.09.1992
(73) Patentinhaber: ROBERT BOSCH GMBH, 70442 Stuttgart (DE)
(72) Erfinder: HAUSSECKER, Walter, D-7582 Buehlertal (DE)
(86) Internationale Anmeldenummer: DE9000872
(87) Internationale Veröffentlichungsnummer: WO9109320

(56) Entgegenhaltungen:
- EP-A- 0 273 129
- DE-A- 3 305 888
- GB-A- 2 064 140
- US-A- 3 248 645

## Beschreibung

### Hallsensor

### Stand der Technik

Die Erfindung betrifft einen Hallsensor nach der Gattung des Patentanspruchs. Ein derartiger Hallsensor ist aus der EP-A 273 129 bekannt. Die Druckschrift zeigt einen Magnetfeldgeber mit einem Permanentmagneten und einem Hallgenerator, wobei der Permanentmagnet als Ringmagnet ausgebildet ist und der Hallgenerator in dem durch Feldverdrängung innerhalb des Ringmagneten gegebenen Raum angeordnet ist. Die Auswerteschaltung des Hallgenerators weist einen dem Hallelement nachgeschalteten Verstärker sowie zwei diesem parallel nachgeordnete Impulsformer auf, welche jeweils zu einem digitalen Schaltungsausgang führen. Die beiden digitalen Ausgänge sind im wesentlichen identisch und dienen gegenseitig zur Kontrolle, indem gegenphasige Signale erzeugt werden. Eine quantitative Aussage über das Ausgangssignal des Hallgenerators ist dabei nicht möglich.

Hallsensoren zur Erfassung von Positionen, Winkelstellungen und Abständen sind in der heutigen Technik weit verbreitet. Bringt man einen Steuermagneten in die Nähe des Hallsensors, so wird in diesem infolge des sich vergrößernden Magnetfelds ein ansteigendes Steuersignal erzeugt. Mit Hilfe einer nachgeschalteten Schwellwertstufe, zum Beispiel eines Schmitt-Triggers, kann die Annäherung des Steuermagneten digital erfaßt werden. So werden Hallsensoren insbesondere mit einem oder mehreren digitalen Ausgängen zur Positionserfassung eingesetzt.

Derartige Sensorsysteme werden beispielsweise auch zur Messung von Umdrehungszahlen einer rotierenden Vorrichtung, zum Beispiel eines elektrischen Stellmotors, eingesetzt, indem an einem drehbaren Teil, zum Beispiel an der Drehwelle, ein Steuermagnet angebracht wird, der bei jeder Umdrehung den Hallsensor passiert und in diesem ein digitales Zählsignal erzeugt. Vor allem bei kleineren Anordnungen ist nach dem Zusammenbau der Zugang zum Sensorsystem praktisch nicht mehr möglich, so daß nicht mehr überprüft werden kann, ob der Abstand zwischen Steuermagnet und Hallsensor korrekt eingestellt ist. Bei höheren Temperaturen verändert sich die Flußdichte (Induktion des Steuermagneten), so daß die Gefahr besteht, daß ab einer bestimmten Temperatur innerhalb eines zulässigen Temperaturbereichs die Sensorsignale nicht mehr zuverlässig erzeugt werden. Es ist andererseits wirtschaftlich insbesondere bei kleinen Vorrichtungen nicht vertretbar, jede dieser Vorrichtungen einem Temperaturtest zu unterziehen. Diese Probleme treten beispielsweise bei Fensterhebermotoren für Kraftfahrzeuge auf.

### Vorteile der Erfindung

Der erfindungsgemäße Hallsensor mit den kennzeichnenden Merkmalen des Anspruchs hat den Vorteil, daß über denselben Hallsensor sowohl die Positionssignale erfaßt und digital ausgegeben werden als auch darüber hinaus eine Überprüfung des Zustands und der Justierung des Sensorsystems durch analoge Erfassung der magnetischen Flußdichte möglich ist. Hierdurch kann nicht nur der Abstand zwischen dem Hallsensor und dem Steuermagneten erfaßt werden, sondern es kann auch überprüft werden, ob die Flußdichte ausreichend hoch ist, um auch innerhalb eines zulässigen Temperaturbereichs eine sichere Auslösung von Sensorsignalen bewirken zu können.

Die Prüfung der Einzelkomponenten des Systems (Hallsensor beziehungsweise Hall-IC- und Steuermagnet) sowie der Baugruppen kann entfallen. Das Symmetrieverhalten des Hall-IC's kann erfaßt werden (Einschalt- zur Ausgangsschwelle).

Während der Abstand zwischen dem Hallsensor und dem Steuermagneten direkt über die gemessene maximale magnetische Flußdichte bestimmt werden kann, wird zur Überprüfung der sicheren Auslösuung von Sensorsignalen auch bei erreichbaren höheren Temperaturen die maximale Flußdichte sowie die Flußdichte im Auslösezeitpunkt eines digitalen Ausgangssignals des Hallsensors bestimmt und in Relation zueinander gesetzt. Übersteigt die maximale Flußdichte die Flußdichte im Auslösezeitpunkt um einen vorbestimmten Toleranzwert entsprechend dem Temperaturkoeffizienten der Induktion des Steuermagneten, so ist das Sensorsystem in einwandfreiem Zustand. Andernfalls besteht die Gefahr, daß bei höheren Temperaturen die Steuersignale ausbleiben. Durch dieses einfache Verfahren kann ein Sensorsystem sehr schnell und kostengünstig überprüft werden.

### Zeichnung

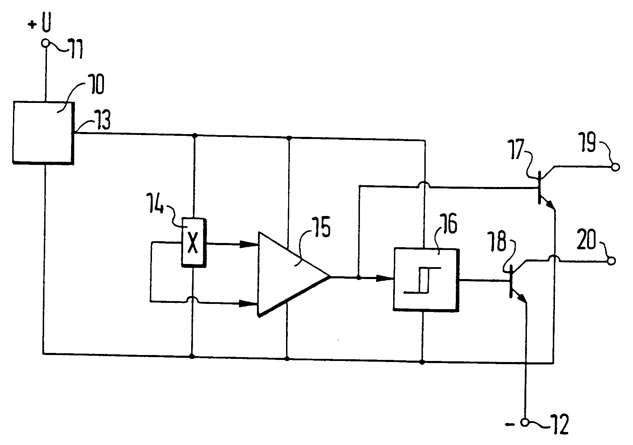

Ein Ausführungsbeispiel der Erfindung ist in der Zeichnung dargestellt und in der nachfolgenden Beschreibung näher erläutert. Die einzige Figur zeigt ein Blockschaltbild des Ausführungsbeispiels.

### Beschreibung des Ausführungsbeispiels

Ein Spannungsregler 10 ist mit zwei Anschlußklemmen 11,12 verbunden, über die eine Versorgungsgleichspannung U angelegt werden kann. Dadurch liegt zwischen dem Ausgang 13 des Spannungsreglers 10 und der mit Masse verbundenen Anschlußklemme 12 eine geregelte Gleichspannung, die an ein Hall-Element 14, einen Verstärker 15 und eine als Schmitt-Trigger 16 ausgebildete Schwellwertstufe angelegt ist.

Zwei Sensorausgänge des Hall-Elements 14 sind mit zwei Verstärkereingängen des Verstärkers 15 verbunden. Der Ausgang des Verstärkers 15 ist zum einen mit der Basis eines ersten Ausgangstransistors 17 und zum anderen mit dem Trigger-Eingang des Schmitt-Triggers 16 verbunden. Der Ausgang des Schmitt-Triggers 16 ist an die Basis eines zweiten Ausgangstransistors 18 gelegt. Während die Emitter der beiden Ausgangstransistoren 17,18 mit der Anschlußklemme 12 verbunden sind, ist der Kollektor des ersten Ausgangstransistors 17 mit einer ersten, analogen Ausgangsklemme 19 und der Kollektor des zweiten Ausgangstransistors 18 mit einer zweiten, digitalen Ausgangsklemme 20 verbunden.

Selbstverständlich können prinzipiell pnp- oder npn-Transistoren verwendet werden. Auch sind andere Arten von digitalen Signalaufbereitungsstufen denkbar. Dies hängt jeweils davon ab, welche Art von Ausgangssignalen erforderlich ist.

Die beschriebenen Bauteile und Baugruppen können in einem integrierten Schaltkreis (IC) zusammengefaßt sein.

Die Funktion des beschriebenen Hall-Sensors besteht darin. daß bei Annäherung eines Steuermagneten an das Hall-Element 14 eine Sensorspannung an dessen Sensorausgängen erzeugt wird, die eine Signalverstärkung im Verstärker 15 erfährt. Die verstärkte Sensorspannung wird einmal über den ersten Ausgangstransistor 17 nochmals verstärkt als analoge Spannung der analogen Ausgangsklemme 19 zugeführt und triggert zum anderen den Schmitt-Trigger 16. Dessen digitales Ausgangssignal wird durch den als Schalttransistor ausgebildeten Ausgangstransistor 18 als verstärkte Schaltspannung der zweiten digitalen Ausgangsklemme 20 zugeführt.

Da sich das analoge Ausgangssignal an der Ausgangsklemme 19 proportional zum Magnetfeld verhält, dem das Hall-Element 14 ausgesetzt ist, kann auf diese Weise beispielsweise der Abstand zwischen dem Steuermagneten und dem Hall-Element 14 bzw. dem Hall-Sensor bestimmt werden. Durch die Möglichkeit einer Magnetfeldmessung neben der Erfassung der eigentlichen Sensorsignale, die z.B. Positionssignale oder Winkelsignale sein können, ist es möglich, mittels eines einzigen Hall-Sensors sowohl die eigentlichen Sensorsignale zu erfassen, als auch den Hall-Sensor selbst zu überprüfen, ob die Magnetfeldstärken bzw. die Flußdichten und/oder der Abstand zum Steuermagneten in ordnungsgemäßem Zustand sind. Hierzu wird beispielsweise das erfaßte maximale analoge Meßsignal in einem Zyklus, der z.B. ein Rotationszyklus sein kann, mit demjenigen Meßsignal verglichen, das zum Zeitpunkt der Triggerung des Schmitt-Triggers 16, also zum Zeitpunkt eines digitalen Positionssignals, vorliegt. Da sich die Flußdichte (Induktion) des Steuermagneten bei höheren Temperaturen verkleinert, kann hochgerechnet werden, ob dieses Steuersignal ausreichend ist, um den Hall-Sensor (bzw. den Hall-IC) bei diesen Extremtemtemperaturen sicher durchzuschalten. Beispielsweise sind Hall- Sensoren in Fensterhebermotoren für Kraftfahrzeuge enthalten, um die Zahl der Umdrehungen der Motorwelle zu bestimmen. Derartige Fensterhebermotoren sind für Temperaturen zwischen -40°C und +120°C auszulegen, wobei in diesem großen Temperaturbereich die Flußdichte des Steuermagneten stark schwankt. Über den analogen Ausgang des Hall-Sensors brauchen jetzt lediglich die beiden genannten Meßwerte bei einer bestimmten Temperatur erfaßt werden. Daraus kann dann hochgerechnet werden, ob das Sensorsystem für den geforderten Temperaturbereich ausgelegt ist, also bei jeder Temperatur die erforderlichen digitalen Steuersignale erzeugt.

Je nach Auslegung und Art des Verstärkers 15 und des Schnitt-Triggers 16 können im Einzelfall die Ausgangstransistoren 17 und 18 auch entfallen. Dies gilt insbesondere für den Ausgangstransistor 17.

## Patentansprüche

1. Hallsensor mit einem Hallelement (14) und einer als Schwellwertstufe (16) mit vorgeschalteter Verstärkerstufe (15) ausgebildeten Signalaufbereitungsstufe mit digitalem Signalausgang, dadurch gekennzeichnet, daß dem Hallelement (14) und der Verstärkerstufe (15) ein zweiter, analoger Signalausgang (19) zugeordnet ist und daß die Bauteile des Hall-Sensors in einem integrierten Schaltkreis (IC) enthalten sind.

## Claims

1. Hall-effect sensor having a Hall-effect element (14) and a signal editing stage, designed as a threshold value stage (16) with an upstream amplifier stage (15), with digital signal output, characterized in that a second, analog signal output (19) is associated with the Hall-effect element (14) and the amplifier stage (15) and in that the components of the Hall-effect sensor are contained in an integrated circuit (IC).

## Revendications

1. Détecteur à effet Hall comportant un élément à effet Hall (14) et un étage de préparation de signal ayant un étage à déclencheur de seuil (16) avec un étage amplificateur précédent, à sorties numériques de signal, détecteur caractérisé en ce qu'une seconde sortie de signal (19) analogique, est associée à l'élément à effet Hall (14) à l'étage amplificateur (15) et les composants du détecteur à effet Hall font partie d'un circuit intégré (IC).
